# EUROPÄISCHE PATENTSCHRIFT

(11) **EP 1 925 944 B1**
(45) Veröffentlichungstag und Bekanntmachung des Hinweises auf die Patenterteilung: **09.01.2013**
(21) Anmeldenummer: 07022823.4
(22) Anmeldetag: 24.11.2007
(51) Int. Cl.: G01R 1/073

(54) **Kontaktiervorrichtung zum Kontaktieren eines zu prüfenden elektrischen Prüflings sowie entsprechendes Kontaktierverfahren**
Contacting device for performing contacting on electric devices to be tested and corresponding contacting method
Dispositif de contact destiné à la mise en contact d'un composant électrique devant être contrôlé ainsi que procédé de mise en contact correspondant

(30) Priorität: 27.11.2006 DE 102006056243; 14.11.2007 DE 102007054187
(43) Veröffentlichungstag der Anmeldung: 28.05.2008
(73) Patentinhaber: Feinmetall GmbH, 71083 Herrenberg (DE)
(72) Erfinder: Schmid, Rainer, 72124 Pliezhausen (DE); Gauss, Ulrich, 71083 Herrenberg (DE)
(74) Vertreter: Grosse, Rainer

(56) Entgegenhaltungen:
- GB-A- 1 316 108
- US-A- 4 901 013
- US-A- 5 214 389

## Beschreibung

Die Erfindung betrifft eine Kontaktiervorrichtung zum Kontaktieren eines zu prüfenden elektrischen Prüflings, insbesondere eines mit verzinnten Kontakten versehenen Prüflings, mit mindestens zwei Führungselementen, die Durchbrüche aufweisen, durch die Kontaktelemente im Wesentlichen axial verlaufen, die auf einer dem Prüfling zugewandten Seite des zugeordneten Führungselements aus diesem zur Kontaktierung des Prüflings mit einer Herausraglänge herausragen.

Eine Kontaktiervorrichtung der eingangs genannten Art ist bekannt. Zur Positionierung und zum Halten von stiftförmigen Kontaktelementen sind diese in Durchbrüchen von mit axialem Abstand zueinander angeordneten Führungselementen gelagert. Die Führungselemente sind als Führungsplatten ausgebildet. Die Durchbrüche sind vorzugsweise als Bohrungen ausgeführt, wobei Führungslängen und Bohrungspositionen feste Parameter sind. Die stiftförmig ausgebildeten Kontakte werden auch als Nadeln bezeichnet, mit deren einen Enden Prüfpunkte des Prüflings kontaktiert werden und deren andere Enden mit einer Kontaktiervorrichtung zusammenwirken, die mit einer elektrischen Prüfeinrichtung verbunden ist. Hierdurch lassen sich Prüfstromkreise schalten, um die Funktion, insbesondere elektrische Funktion, des Prüflings zu testen. Die Nadelenden, die den Prüfling kontaktieren, können bei einer speziellen Bauform ohne Spitze versehen sein, also flach verlaufen, wenn insbesondere Lötpunkte des Prüflings kontaktiert werden sollen. Erfolgt ein häufiges Kontaktieren des Prüflings, so führt dies zu einem Verschmutzen der Nadelenden. Der Schmutz wird von Zeit zu Zeit vorzugsweise abrassiv entfernt, also abgeschliffen, wobei auch immer ein Bruchteil der Länge der Nadeln mit abgeschliffen wird. Durch diesen relativ starken Verschleiß der Nadeln kommt es zu einer entsprechenden Nadelverkürzung, sodass sie ausgetauscht werden müssen, wenn eine minimale Länge erreicht ist.

D1 = US 4 901 013 offenbart eine Kontaktiervorrichtung zum Kontaktieren eines elektrischen Prüflings in der die Herausraglänge der Kontaktelemente durch eine Einstellvorrichtung einstellbar ist.

D2 = GB 1 316 108 offenbart eine Kontaktiervorrichtung mit aus- und einziehbaren Kontaktelementen.

D3 = US 5 214 389 offenbart eine Kontaktiervorrichtung in der die Kontaktelemente durch Piezo-Ansteuerung positioniert werden.

Der Erfindung liegt die Aufgabe zugrunde, die Standzeit von Kontaktelementen, insbesondere Nadeln, bei Kontaktiervorrichtungen entscheidend zu verlängern.

Diese Aufgabe wird erfindungsgemäß dadurch gelöst, dass der axiale Abstand der Führungselemente oder die axiale Lage des dem Prüfling zugewandten Führungselement zur Anpassung der Herausraglänge einstellbar ist. Durch diese Möglichkeiten der axialen Verlagerung der Führungselemente relativ zueinander oder der axialen Verlagerung des dem Prüfling zugewandten Führungselements lässt sich erreichen, dass die Nadeln nach Abnutzung wieder einen genügend großen Überstand erhalten, um eine gute Kontaktierung zu gewährleisten. Es ist dabei unerheblich, ob die Nadeln eine Kontaktspitze haben oder ob sie flachgeschliffen ausgebildet sind. Die flache Ausbildung hat allerdings den Vorteil, dass bei der zum Säubern der Nadelspitzen erfolgenden abrassiven Behandlung die Form der Nadelenden erhalten bleibt. Liegen angespitzte Nadeln vor, so führt das Abschleifen auch zu einer Verkürzung der Spitzen. Ein weiterer Vorteil des Gegenstandes der Erfindung besteht darin, dass der Überstand, also die Herausraglänge, der Nadelenden relativ kurz gehalten werden kann, da die erfindungsgemäße Anpassungsmöglichkeit besteht, wobei die kurze Führung eine gute Führung gewährleistet, was wiederum eine gute Positionierung und somit eine gute Kontaktierung bedeutet.

Nach einer Weiterbildung der Erfindung ist vorgesehen, dass der axiale Abstand der Führungselemente mittels mindestens einer Einstellvorrichtung einstellbar ist. Die Einstellvorrichtung sorgt für eine axiale Verlagerung des Führungselements, mit dem Ziel, die Herausraglänge der Kontaktelemente einzustellen beziehungsweise nachzujustieren.

Vorzugsweise kann es sich bei der Einstellvorrichtung um eine kontinuierliche Einstellvorrichtung und/oder eine stufenförmige Einstellvorrichtung handeln. Die kontinuierliche Einstellvorrichtung erlaubt ein stufenfreies Einstellen, während die stufenförmige Einstellvorrichtung eine Verlagerung des zugehörigen Führungselements in vorgegebenen Distanzsprüngen ermöglicht.

Eine kontinuierliche Einstellung ist insbesondere dann gegeben, wenn die Einstellvorrichtung vorzugsweise als Verstellgewindeeinrichtung ausgebildet ist. Wird mindestens eine Gewindeanordnung der genannten Einstellvorrichtung verdreht, so verlagert sich dementsprechend kontinuierlich das zugehörige Führungselement in axialer Richtung.

Es ist vorteilhaft, wenn die Einstellvorrichtung eine pneumatische, hydraulische und/oder Piezo-Verstellvorrichtung ist. Demzufolge lässt sich der axiale Abstand der Führungselemente mittels der pneumatischen Einstellvorrichtung einstellen, also per Luftdruck. Alternativ ist auch eine hydraulische Einstellvorrichtung möglich, bei der die genannte Einstellung mittels eines Hydraulikmediums erfolgt. Da die Verstellwege relativ klein sind, ist es auch denkbar, dass die Einstellvorrichtung eine Piezo-Verstellvorrichtung ist. Diese verändert eine Piezostrecke in ihrer Länge dadurch, dass diese mit einer mehr oder weniger großen elektrischen Spannung beaufschlagt wird. Durch Einstellung der elektrischen Spannung lässt sich demzufolge eine mechanische Verstellung erreichen, die wiederum zur Verstellung des zugehörigen Führungselements führt.

Nach einer Weiterbildung der Erfindung ist vorgesehen, dass die Einstellvorrichtung eine vorzugsweise im Wesentlichen radial verlagerbare Keil- und/oder Treppenvorrichtung ist. Vorzugsweise stützt sich das den Endbereichen der Kontaktelemente zugeordnete Führungselement an einem axial beabstandeten, weiteren Führungselement ab. Diese Abstützung der beiden Führungselemente wird vorzugsweise mittels der Einstellvorrichtung vorgenommen. Ist diese in der Länge veränderbar, insbesondere als Keil- und/oder Treppenvorrichtung ausgebildet, so wird deutlich, dass je nach Keilgröße und/oder Treppenstufe der Abstand der beiden Führungselemente einstellbar ist, wodurch in entsprechender Weise die Herausraglänge der Kontaktelemente eingestellt werden kann. Bei einer Keilvorrichtung erfolgt dies kontinuierlich und bei einer Treppenvorrichtung diskontinuierlich, also in Stufen.

Eine Weiterbildung der Erfindung sieht vor, dass die Einstellvorrichtung als Entnahmeeinrichtung ausgebildet ist, wobei sich durch die Entnahme der axiale Abstand zwischen den Führungselementen verkleinert. Wie bereits erwähnt, ist zwischen den beiden Führungselementen die Einstellvorrichtung angeordnet. Kann diese entnommen werden, so verkleinert sich der Abstand zwischen den Führungselementen, wobei die Führungselemente aufeinandertreffen, wenn nur eine Einstellvorrichtung zwischen ihnen angeordnet war und nunmehr entnommen ist. Es ist natürlich auch denkbar, dass in axialer Richtung mehrere Einstellvorrichtungen zueinander in Reihe angeordnet sind, die alle als Entnahmeeinrichtung ausgebildet sind, oder dass die Einstellvorrichtung mehrere entnehmbare Elemente aufweist. Wird nun eine der Entnahmeeinrichtungen oder eines der Elemente entnommen, so verkleinert sich der axiale Abstand zwischen den Führungselementen um ein entsprechendes Stück, was zu einer entsprechenden Vergrößerung der Herausraglänge der Kontaktelemente führt. Die Entnahme einer weiteren Entnahmeeinrichtung oder eines weiteren Elements, wenn sich die Kontaktelement durch Abschleifen in ihrer Länge weiter verkleinert haben, führt wiederum dazu, dass eine Korrektur der Herausraglänge durchgeführt werden kann. Dieser Vorgang kann entsprechend oft wiederholt werden und ist von der Anzahl der in Reihe zueinander liegenden Entnahmeeinrichtungen oder Elemente abhängig.

Aus dem Vorstehenden wird deutlich, dass der axiale Abstand der Führungselemente mittels mindestens eines zwischen ihnen angeordneten Elements oder dergleichen einstellbar ist. Da sich die Führungselemente an diesem Element abstützen, bildet das Element einen Abstandshalter. Lässt sich der Abstandshalter vorzugsweise in seiner Dicke verändern, so ergibt sich die erfindungsgemäße Möglichkeit, die Herausraglänge der Kontaktelemente einzustellen. Bei der vorstehend erwähnten Einstellvorrichtung ist es denkbar, dass diese - wie auch bereits erwähnt - zwischen den Führungselementen angeordnet ist. Alternativ kann jedoch auch vorgesehen sein, dass sie einem anderen Bauteil der Kontaktiervorrichtung zugeordnet ist und dennoch die axiale Position des den Enden der Prüfkontakte zugeordneten Führungselements zur Einstellung der Herausraglänge verändert. Bei dem erwähnten, mindestens einen Abstandshalter ist dieser zwischen den mindestens beiden Führungselementen angeordnet, das heißt die Führungselemente stützen sich an dem Abstandshalter unmittelbar oder mittelbar ab. Der Abstandshalter kann bevorzugt in seiner Dicke verändert werden. Hierzu kann wiederum eine Einstellvorrichtung und/oder Verstellgewindevorrichtung und/oder pneumatische, hydraulische und/oder Piezo-Verstellvorrichtung und/oder Keilvorrichtung und/oder Treppenvorrichtung und/oder Entnahmevorrichtung vorgesehen sein.

Nach einer Weiterbildung der Erfindung ist vorgesehen, dass der axiale Abstand mittels mindestens eines herausnehmbaren und/oder im Wesentlichen radial verlagerbaren Abstandshalter einstellbar ist. Der herausnehmbare Abstandshalter kann insbesondere rahmenartig ausgebildet sein oder sich aus Rahmenteilen zusammensetzen. Hierbei ist es vorteilhaft, wenn die rahmenartige Ausbildung als zumindest an einer Seite offene Rahmenanordnung ausgebildet ist. Auf diese Art und Weise ist es möglich, U-förmige Rahmenteile zu realisieren. Werden nun insbesondere mehrere derartiger Abstandshalter vorgesehen, die aufeinandergestapelt und einzeln entnehmbar sind, so lässt sich, je nach der Anzahl der entnommenen Abstandshalter, die Herausraglänge einstellen, wobei dieser Vorgang auch zeitlich aufeinanderfolgend durchgeführt werden kann, das heißt, immer nach einer entsprechenden Abnutzung der Kontaktelemente wird mindestens ein Abstandshalter der axial aufeinander liegenden Abstandshalter entnommen.

Sind die Abstandshalter rahmenartig ausgebildet, insbesondere U-förmig, so werden sie bevorzugt um eine axiale Achse drehversetzt zueinander angeordnet, das heißt, nicht alle U's liegen fluchtend aufeinander, sondern sind beispielsweise um 180° zueinander drehversetzt oder um 90° zueinander drehversetzt angeordnet, sodass sich eine in sich festere und besser abstützende, innen Platz für die Kontaktelemente aufweisende Struktur ergibt.

Die Erfindung betrifft ferner ein Verfahren zum Kontaktieren eines zu prüfenden elektrischen Prüflings, insbesondere eines mit verzinnten Kontakten versehenen Prüflings, bevorzugt unter Einsatz der vorstehend erwähnten Kontaktiervorrichtung, wobei das Kontaktieren mittels im Wesentlichen axial verlaufender Kontaktelemente erfolgt, die durch mindestens zwei Führungselemente verlaufen, wobei die Kontaktelemente auf einer dem Prüfling zugewandten Seite des zugeordneten Führungselements aus diesem zur Kontaktierung des Prüflings herausragen und wobei der axiale Abstand der Führungselemente oder die axiale Lage des dem Prüfling zugewandten Führungselements zur Anpassung der Herausraglänge eingestellt wird/einstellbar ist.

Die Zeichnungen veranschaulichen die Erfindung anhand von Ausführungsbeispielen, und zwar zeigt:
- Figur 1: eine schematische, vergrößerte Darstellung einer Kontaktiervorrichtung zum Kontaktieren eines zu prüfenden elektrischen Prüflings,
- Figur 2: einen Abstandshalter für die Kontaktiervorrichtung zum Einstellen der Herausraglänge von Kontaktelementen,
- Figur 3: eine Kontaktiervorrichtung nach einem anderen Ausführungsbeispiel,
- Figur 4: eine Kontaktiervorrichtung nach einem anderen Ausführungsbeispiel und
- Figur 5: eine Kontaktiervorrichtung nach einem weiteren Ausführungsbeispiel.

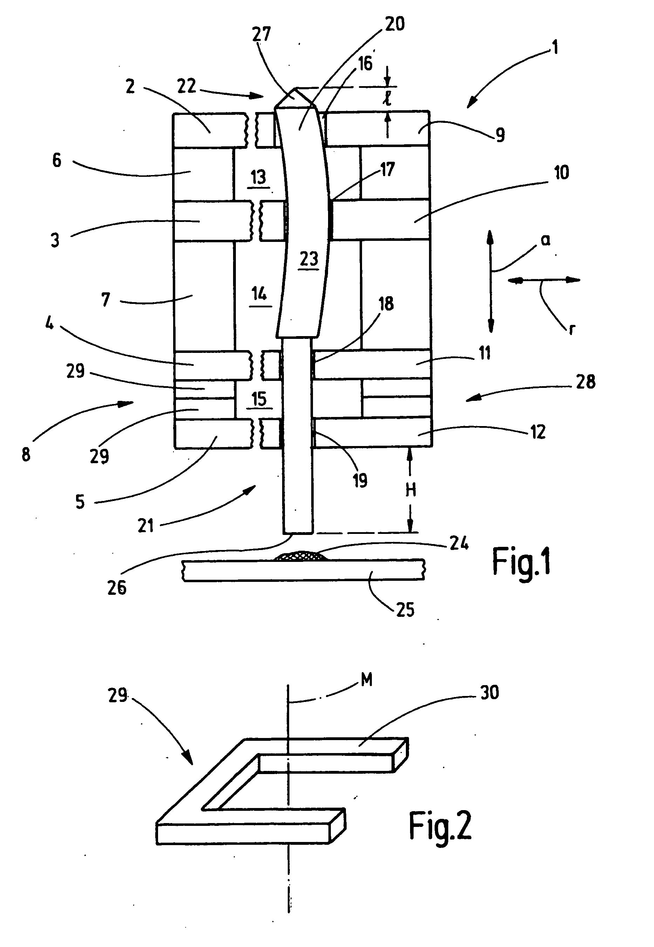

Die Figur 1 zeigt eine Kontaktiervorrichtung 1, die vergrößert und lediglich schematisch dargestellt ist. Sie weist vier in axialer Richtung a mit Abstand und parallel zueinander angeordnete Führungselemente 2, 3, 4 und 5 auf, zwischen denen Abstandselemente 6, 7 und 8 angeordnet sind. Im Einzelnen ist das Abstandselement 6 zwischen den Führungselementen 2 und 3, das Abstandselement 4 zwischen den Führungselementen 3 und 4 und das Abstandselement 8 zwischen den Führungselementen 4 und 5 positioniert. Die Führungselemente 2, 3, 4 und 5 sind als Führungsplatten 9, 10, 11 und 12 ausgebildet und die Abstandselemente 6, 7 und 8 rahmenartig, sodass im Innern der Kontaktiervorrichtung Freiräume 13, 14 und 15 ausgebildet werden. Die elektrisch nichtleitenden Führungsplatten 9 bis 12 weisen jeweils eine Vielzahl von Durchbrüchen 16, 17, 18 und 19 auf, wobei die Durchbrüche 16, 18 und 19 axial miteinander fluchten und der Durchbruch 17 zur Fluchtungslinie in radialer Richtung r versetzt liegt. Ein Kontaktelement 20 ist in den Durchbrüchen 16 bis 19 axial eingeschoben angeordnet, derart, dass es mit einem Endbereich 21 aus dem Durchbruch 19 der Führungsplatte 12 mit einer Herausraglänge H herausragt. Aus dem Durchbruch 16 der Führungsplatte 9 schaut das andere Ende des Kontaktelements 20 mit einem Endbereich 22 eine Länge I heraus. Die Anordnung ist so getroffen, dass das Kontaktelement 20 bereichsweise mit einer Isolierung 23 und im Bereich der Führungsplatten 11 und 12 ohne Isolierung versehen ist. In diesem letztgenannten Bereich besteht das Kontaktelement demzufolge aus elektrisch gut leitendem, blankliegendem Material. Alternativ ist es auch möglich, Kontaktelemente 20 ohne Isolierung zu verwenden. Durch den Versatz des Durchbruchs 17 relativ zu den anderen Durchbrüchen 16, 18 und 19 erhält das eigenelastische Kontaktelement 20 eine Biegung, wodurch es selbsthaltend, jedoch axial verschieblich in der Kontaktvorrichtung gehalten ist. Die Durchbrüche 16 bis 19 sind vorzugsweise als Bohrungen ausgebildet, die insbesondere per Laserstrahl erzeugt sind. Der Durchmesser des Kontaktelements 20 ist relativ klein, er ist beispielsweise etwa so groß wie der Durchmesser eines menschlichen Haares.

Der Figur 1 ist zu entnehmen, dass die Führungsplatten 9 bis 12 jeweils gebrochen dargestellt sind, das heißt, der Einfachheit halber ist die Kontaktiervorrichtung 1 nur mit einem einzigen Kontaktelement 20 dargestellt. In realer Ausführung sind eine Vielzahl derartiger Kontaktelement vorgesehen, um eine entsprechende Anzahl von Prüfpunkten 24 eines elektrisch zu prüfenden Prüflings 25 jeweils mit der Stirnfläche 26 der Kontaktelemente 20 kontaktieren zu können. Hierzu wird der Prüfling 25 in Richtung auf die Stirnflächen 26 bewegt. Das gegenüberliegende Ende 27 des jeweiligen Kontaktelements 20 tritt dabei gegen eine Gegenkontaktfläche (nicht dargestellt), die mit einer elektronischen Prüfeinrichtung verbunden ist. Auf diese Art und Weise lassen sich Strompfade zum Prüfling 25 herstellen, um diesen auf Funktion zu prüfen.

Die Kontaktelemente sind vorzugsweise als Kontaktstifte, insbesondere als Kontaktnadeln ausgebildet. Aufgrund ihrer Krümmung werden sie auch als Knicknadeln bezeichnet.

Bei der Prüfung kontaktiert das Stirnende 26 des Endbereichs 21 den Prüfpunkt 24 des Prüflings 25, wobei im vorliegenden Falle der Prüfpunkt 24 von einem Lötpunkt gebildet ist, also ein erhabener Zinnkopf ist. Durch viele Kontaktierungsvorgänge verschmutzt der den Prüfling kontaktierende Endbereich des Kontaktelements 20, sodass dieser von Zeit zu Zeit abrassiv gereinigt wird. Dabei wird nicht nur der Schmutz entfernt, sondern stets auch Material des Kontaktelements 20, mit der Folge, dass dieses entsprechend kürzer wird. Damit verkleinert sich die Herausraglänge H, mit der Folge, dass nach einer entsprechenden Anzahl von Reinigungsvorgängen das Kontaktelement 20 ausgetauscht werden müsste. Dies ist jedoch aufgrund der Erfindung nicht nötig, da die Herausraglänge H durch eine erfindungsgemäße Abstandsveränderung der Führungselemente 4 und 5 einstellbar ist. Hierzu ist zwischen den Führungselementen 4 und 5, also zwischen den Führungsplatten 11 und 12, eine Einstellvorrichtung 28 angeordnet oder - als alternative Ausführung - dem Führungselement 5 eine sich nicht am Führungselement 4 abstützende, sondern an einem anderen Teil der Kontaktiervorrichtung 1 befestigten Einstelleinrichtung 28 zugeordnet, sodass das Führungselement 5 relativ zum Führungselement 4 axial verstellt beziehungsweise axial verstellt werden kann. Beim Ausführungsbeispiel der Figur 1 ist vorgesehen, dass die Einstellvorrichtung 28 aus mehreren Abstandshaltern 29 besteht, die axial aufeinanderliegen. Die Abstandshalter 29 sind gemäß Figur 2 jeweils rahmenartig ausgebildet, das heißt, es sind U-förmige Rahmenteile 30. Der Maßstab der Figur 2 stimmt nicht mit dem Maßstab der Figur 1 überein; in der Figur 2 liegt eine Verkleinerung gegenüber dem Maßstab der Figur 1 vor. Es ist jedoch ersichtlich, dass das Aufeinanderstapeln von mehreren U-förmigen Rahmenteilen 30 zur Ausbildung einer Einstellvorrichtung 28 führt, die zwischen den Führungsplatten 11 und 12 angeordnet wird und damit den Abstand der Führungsplatten 11 und 12 bestimmt. Das Aufeinanderstapeln erfolgt vorzugsweise drehversetzt um eine Mittelachse M (Figur 2), beispielsweise sind bei Verwendung von zwei U-förmigen Rahmenteilen diese um 180° zueinander verdreht angeordnet. Sind mehr als zwei U-förmige Rahmenteile 30 vorgesehen, so sind diese bevorzugt jeweils um einen 90° Winkel zueinander versetzt.

Ragt der Endbereich 21 nach mehrfachem Reinigungsvorgang nicht mehr weit genug aus dem Durchbruch 19 der Führungsplatte 12 heraus, so wird ein Abstandshalter 29, also ein U-förmiges Rahmenteil 30, nach vorheriger Lockerung der entsprechenden Teile entnommen und anschließend die Vorrichtung wieder fest verschraubt oder verpresst oder dergleichen. Die Folge ist, dass sich die Herausraglänge H entsprechend der Dicke des herausgenommenen Abstandshalters 29 vergrößert, sodass wieder eine hinreichende Herausraglänge H vorliegt. Dieser Vorgang kann mehrfach wiederholt werden, je nach Anzahl der verwendeten Abstandshalter 29.

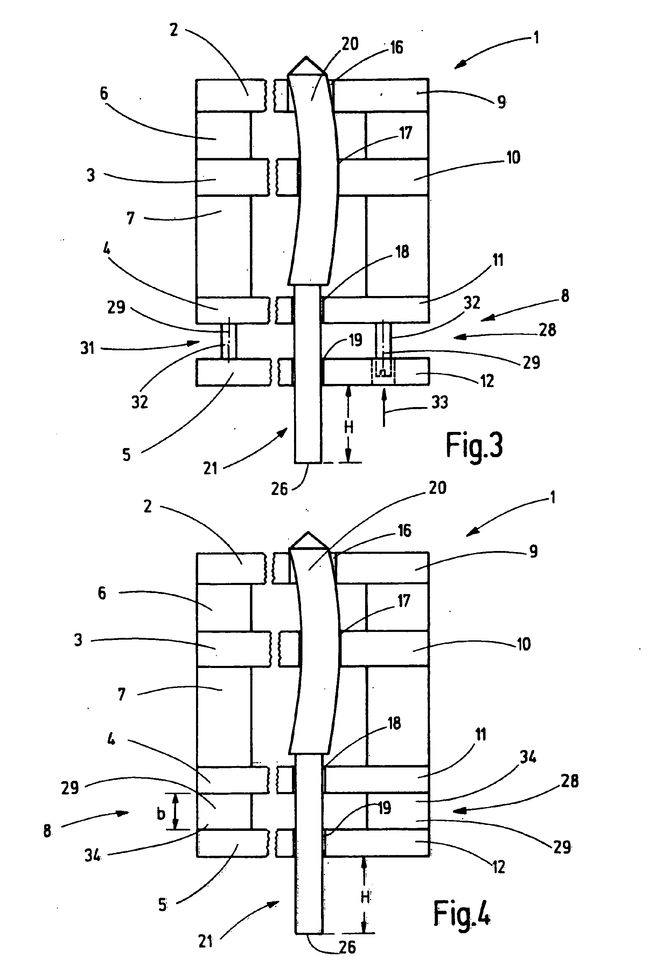

Die Figur 3 zeigt ein der Figur 1 entsprechendes Ausführungsbeispiel, sodass auf die vorstehende Beschreibung verwiesen wird. Unterschiedlich ist lediglich, dass die Einstellvorrichtung 28 in diesem Falle als Verstellgewindeeinrichtung 31 ausgebildet ist. Hierzu halten vorzugsweise mehrere Gewindestifte 32 die Führungsplatten 11 und 12 auf axialen Abstand. Werden die Gewindestifte 32 durch Einsetzen eines entsprechenden Werkzeugs (Pfeil 33) verdreht, so ändert sich der Abstand zwischen den Führungsplatten 11 und 12, mit der Folge, dass hierdurch die Herausraglänge H einstellbar ist. Hierzu ist es erforderlich, dass die Gewindestifte 32 an ihren Endbereichen gegenläufige Gewinde aufweisen. Sie ragen hiermit in entsprechende Gewindebohrungen der Führungsplatten 11 und 12 hinein. Dies ist bei einem der Gewindestifte 32 im Bereich der Führungsplatte 12 in Figur 3 angedeutet. Mittels der Verstellgewindeeinrichtung 31 ist eine kontinuierliche Einstellung möglich, das heißt, es liegt eine kontinuierlich arbeitende Einstellvorrichtung 28 vor.

Die Figur 4 zeigt ein weiteres Ausführungsbeispiel, das wiederum dem Ausführungsbeispiel der Figur 1 entspricht, sodass auf die Beschreibung Bezug genommen wird. Unterschiedlich ist lediglich die Ausgestaltung der Einstellvorrichtung 28, die in diesem Falle als Piezo-Verstellvorrichtung 34 ausgebildet ist. Diese ist zwischen den Führungsplatten 11 und 12 angeordnet und kann mittels einer nicht dargestellten elektrischen Spannungsquelle beaufschlagt werden, mit der Folge, dass sich die Länge b in Abhängigkeit von der Spannungshöhe verändert, sodass damit der Abstand zwischen den Führungsplatten 11 und 12 und damit die Herausraglänge H des Kontaktelements 20 einstellbar ist.

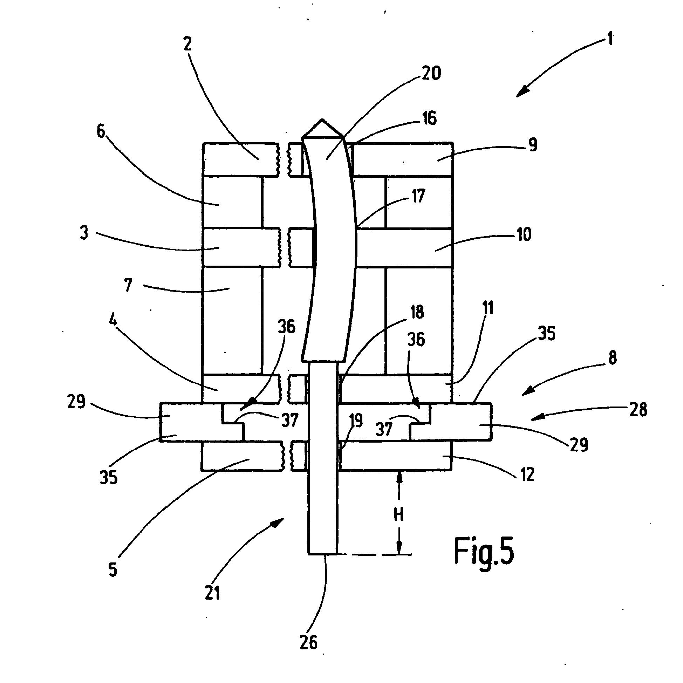

Die Figur 5 zeigt ein weiteres Ausführungsbeispiel einer Kontaktiervorrichtung 1, die wiederum dem Ausführungsbeispiel der Figur 1 entspricht und sich lediglich in der Einstellvorrichtung 28 unterscheidet, die in diesem Falle als Treppenvorrichtung 35 ausgebildet ist. Es sind zwei Treppenvorrichtungen 35 vorgesehen, die als Abstandshalter 29 dienen und aufgrund einer jeweiligen Treppenausbildung 36 unterschiedliche Dicke aufweisen. In der aus der Figur 5 hervorgehenden Stellung der beiden Treppenvorrichtungen 35 wird die Maximaldicke dieser Vorrichtungen benutzt, um die Führungsplatten 11 und 12 auf einen entsprechenden Abstand zu halten. Reicht die Herausraglänge H des Kontaktelements 20 nicht mehr aus, so können die beiden Treppenvorrichtungen 35 - nach vorheriger Lockerung entsprechender Bauteile - radial nach außen versetzt werden, mit der Folge, dass die Führungsplatte 11 beim anschließendem Zusammenbau auf einer Treppenfläche 37 der jeweiligen Treppenvorrichtung 35 aufsitzt, wodurch der Abstand zwischen den Führungsplatten 11 und 12 verkleinert ist und demzufolge die Herausraglänge H um das entsprechende Maß vergrößert wird.

Die Dicke der Abstandshalter 29 gemäß Figur 1 beträgt vorzugsweise 150 µm und ist damit so gewählt, dass nach einem Herausziehen einer Distanzlage ein genügend langer, jedoch nicht zu langer Kontaktelementüberstand (Herausraglänge H) im Verhältnis zum Durchmesser des Kontaktelements 20 resultiert.

## Patentansprüche

1. Kontaktiervorrichtung (1) zum Kontaktieren eines zu prüfenden elektrischen Prüflings (25), mit mindestens zwei Führungselementen (2,3,4,5), die Durchbrüche (16,17,18,19) aufweisen, durch die Kontaktelemente (20) im Wesentlichen axial verlaufen, die auf einer dem Prüfling (25) zugewandten Seite des zugeordneten Führungselements (5) aus diesem zur Kontaktierung des Prüflings (25) herausragen, wobei der axiale Abstand der Führungselemente (2,3,4,5) zur Anpassung der Herausraglänge (H) mittels einer Einstellvorrichtung (28) einstellbar ist, **dadurch gekennzeichnet, dass** bei der Einstellvorrichtung (28) der axiale Abstand mittels mehrerer, aufeinander liegender, einzeln herausnehmbarer Abstandshalter (29) einstellbar ist, wobei die Abstandshalter (29) rahmenartig ausgebildet sind und die rahmenartige Ausbildung mittels U-förmiger Rahmenteile (30) gebildet ist, die um eine Mittelachse (M) drehversetzt zueinander angeordnet sind, oder dass die Einstellvorrichtung (28) eine Verstellgewindeeinrichtung (31) ist, oder dass die Einstellvorrichtung (28) eine Piezo-Verstellvorrichtung (34) ist.

2. Kontaktiervorrichtung nach Anspruch 1, **dadurch gekennzeichnet, dass** bei zwei U-förmigen Rahmenteilen (30) diese um 180° zueinander verdreht angeordnet sind.

3. Kontaktiervorrichtung nach Anspruch 1, **dadurch gekennzeichnet, dass** bei mehr als zwei U-förmigen Rahmenteilen (30) diese jeweils um 90° zueinander versetzt angeordnet sind.

4. Kontaktiervorrichtung nach Anspruch 1, **dadurch gekennzeichnet, dass** die Führungselemente (2,3,4,5) als Führungsplatten (11,12) ausgebildet sind.

5. Kontaktiervorrichtung nach Anspruch 4, **dadurch gekennzeichnet, dass** die Verstellgewindeeinrichtung (31) mehrere die Führungsplatten (11,12) auf axialen Abstand haltende Gewindestifte (32) aufweist.

6. Kontaktiervorrichtung nach Anspruch 5, **dadurch gekennzeichnet, dass** die Gewindestifte (32) in ihren Endbereichen gegenläufige Gewinde aufweisen, die in entsprechende Gewindebohrungen der Führungsplatten (11,12) hineinragen.

7. Kontaktiervorrichtung nach Anspruch 4, **dadurch gekennzeichnet, dass** die Piezo-Verstellvorrichtung (34) zwischen den Führungsplatten (11,12) angeordnet und mittels einer elektrischen Spannungsquelle zum spannungshöhenabhängigen Verändern der Länge der Piezo-Verstellvorrichtung (34) beaufschlagbar ist.

## Claims

1. A contacting device (1) for contacting an electric test object (25), which is to be tested, comprising at least two guide elements (2, 3, 4, 5), which encompass apertures (16, 17, 18, 19), through which contact elements (20) run in a substantially axial manner and which, on a side of the corresponding guide element (5) that faces the test object (25), project out of it for contacting the test object (25), wherein the axial distance of the guide elements (2, 3, 4, 5) can be adjusted to adapt the length of projection (H) by means of an adjusting device (28), **characterized in that**, in the case of the adjusting device (28), the axial distance can be adjusted by means of a plurality of spacers (29), which are located on top of one another and which can be removed individually, wherein the spacers (29) are embodied in a frame-like manner, and the frame-like embodiment is formed by means of U-shaped frame parts (30), which are arranged so as to be rotationally staggered relative to one another about a central axis (M), or that the adjusting device (28) is an adjustable threaded device (31) or that the adjusting device (28) is a piezo adjusting device (34).

2. The contacting device according to claim 1, **characterized in that**, in the case of two U-shaped frame parts (30), the latter are arranged so as to be rotated relative to one another by 180°.

3. The contacting device according to claim 1, **characterized in that**, in the case of more than two U-shaped frame parts (30), the latter are in each case arranged so as to be offset relative to one another by 90°.

4. The contacting device according to claim 1, **characterized in that** the guide elements (2, 3, 4, 5) are embodied as guide plates (11, 12).

5. The contacting device according to claim 4, **characterized in that** the adjustable threaded device (31) encompasses a plurality of threaded pins (32), which hold the guide plates (11, 12) at an axial distance.

6. The contacting device according to claim 5, **characterized in that**, in their end regions, the threaded pins (32) encompass threads, which run in opposite direction and which project into corresponding tapped bores of the guide plates (11, 12).

7. The contacting device according to claim 4, **characterized in that** the piezo adjusting device (34) is arranged between the guide plates (11, 12) and that an electric voltage source can act on it for changing the length of the piezo adjusting device (34) in a voltage level-dependent manner.

## Revendications

1. Dispositif de mise en contact (1) pour la mise en contact d'un échantillon électrique à contrôler (25), comprenant au moins deux éléments de guidage (2, 3, 4, 5) qui présentent des ajours (16, 17, 18, 19) à travers lesquels des éléments de contact (20) s'étendent essentiellement de manière axiale, qui font saillie depuis l'élément de guidage associé (5) sur un côté de celui-ci tourné vers l'échantillon (25) pour la mise en contact de l'échantillon (25), dans lequel l'écart axial des éléments de guidage (2, 3, 4, 5) peut être réglé pour l'adaptation de la longueur de saillie (H) au moyen d'un dispositif de réglage (28), **caractérisé en ce que**, pour le dispositif de réglage (28), l'écart axial peut être réglé au moyen de plusieurs écarteurs superposés (29) pouvant être extraits individuellement, dans lequel les écarteurs (29) sont réalisés à la manière d'un cadre et la réalisation à la manière d'un cadre est formée au moyen de parties de cadre en U (30) qui sont disposées de manière décalée en rotation l'une par rapport à l'autre autour d'un axe central (M), ou que le dispositif de réglage (28) est un dispositif à filet de réglage (31), ou que le dispositif de réglage (28) est un dispositif de réglage piézo (34).

2. Dispositif de mise en contact selon la revendication 1, **caractérisé en ce que**, dans le cas de deux parties de cadre en U (30), celles-ci sont disposées de manière tournée à 180° l'une par rapport à l'autre.

3. Dispositif de mise en contact selon la revendication 1, **caractérisé en ce que**, dans le cas de plus de deux parties de cadre en U (30), celles-ci sont disposées de manière décalée de 90° à chaque fois l'une par rapport à l'autre.

4. Dispositif de mise en contact selon la revendication 1, **caractérisé en ce que** les éléments de guidage (2, 3, 4, 5) sont réalisés en tant que plaques de guidage (11, 12).

5. Dispositif de mise en contact selon la revendication 4, **caractérisé en ce que** le dispositif à filet de réglage (31) présente plusieurs vis sans tête (32) maintenant les plaques de guidage (11, 12) à un écart axial.

6. Dispositif de mise en contact selon la revendication 5, **caractérisé en ce que** les vis sans tête (32) présentent des filetages contraires dans leurs zones d'extrémité qui dépassent dans des alésages filetés correspondants des plaques de guidage (11, 12).

7. Dispositif de mise en contact selon la revendication 4, **caractérisé en ce que** le dispositif de réglage piézo (34) est disposé entre les plaques de guidage (11, 12) et peut être sollicité au moyen d'une source de tension électrique pour la modification de la longueur du dispositif de réglage piézo (34) en fonction de la hauteur de tension.
